# EUROPÄISCHE PATENTSCHRIFT

(11) **EP 0 898 394 B1**
(45) Veröffentlichungstag und Bekanntmachung des Hinweises auf die Patenterteilung: **28.11.2007**
(21) Anmeldenummer: 98115730.8
(22) Anmeldetag: 20.08.1998
(51) Int. Cl.: H04B 7/26, H04J 3/02

(54) **Verfahren und Vorrichtung zur Synchronisation zweier Taktsignale und Signalwandler**
Method and device for synchronisation of two clock signals and a signal processor
Dispositif et méthode de synchronisation de deux signaux d'horloge et un processeur numérique

(30) Priorität: 20.08.1997 DE 19736185
(43) Veröffentlichungstag der Anmeldung: 24.02.1999
(73) Patentinhaber: Infineon Technologies AG, 81669 München (DE)
(72) Erfinder: Kranz, Christian, 40885 Ratingen Lintorf (DE); Becker, Burkhard, 85737 Ismaning (DE)
(74) Vertreter: Jannig, Peter

(56) Entgegenhaltungen:
- EP-A- 0 946 016
- US-A- 5 132 642
- US-A- 5 517 521

## Beschreibung

Die Erfindung betrifft einen Signalwandler, der zum Betrieb in nicht synchronisierten Taktsystemen geeignet ist und ein Verfahren sowie eine Vorrichtung zur Synchronisation zweier Taktsignale.

Der Signalwandler setzt einen empfangenen Bitdatenstrom in ein analoges Ausgangssignal um, welches beispielsweise einem Lautsprecher zugeführt werden kann. Umgekehrt wandelt der Signalwandler ein beispielsweise von einem Mikrophon stammendes analoges Signal in einen Bitdatenstrom um. Der Bitdatenstrom kann dann beispielsweise von einer Sendeeinheit eines Mobilteils, welches nach dem DECT-Standard arbeitet, ausgesandt werden.

Die Erfindung ist unter anderem bei Schnurlostelefonen nach dem DECT-Standard, wobei DECT für Digital Enhanced Cordless Telephone steht, einsetzbar. Das DECT-Netz ist ein mikrozellulares, digitales Mobilfunknetz für hohe Teilnehmerdichten. Es wird dabei ein TDMA-Verfahren (Time Division Multiple Access) bei 10 Trägerfrequenzen verwendet. Diese liegen in einem Frequenzband von 1880 bis 1900 MHz. Ein nach dem DECT-Standard arbeitendes Schnurlostelefon empfängt einen Bitdatenstrom mit einer Bitrate von 1152 Kilobit pro Sekunde als Informationssignal, in folgenden auch als Empfangsbitstrom bezeichnet. Daneben werden von dem Schnurlostelefon Daten mit einer Bitrate von ebenfalls 1152 Kilobit pro Sekunde ausgesandt. Im folgenden wird dieser Datenstrom als Sendebitstrom bezeichnet.

Aus dem Empfangsbitstrom wird mittels eines Burstmodecontrollers ein Synchronisationssignal gewonnen, das zum Takten der nachgeschalteten Signalverarbeitungseinheit dient. Ein oder mehrere Filter bereiten das von der Signalverarbeitungseinheit bzw. einem Codec stammende Signal auf und reichen es an den Codec bzw. die Signalverarbeitungseinheit weiter. Werden das bzw. die Filter mittels eines systeminternen Takts getaktet, so kann es zu einer Asynchronität zwischen dem von dem Burstmodecontroller stammenden Synchronisationssignal und dem von der systeminternen Takterzeugungseinheit stammenden Taktsignal kommen. Dies wiederum kann zu Störungen in Form von Signalverdopplung oder zu Signalverlusten führen. Bei der Übertragung von Modemsignalen kann dies nicht hingenommen werden, da dadurch eine optimale Ausnutzung der Bitrate nicht mehr möglich ist.

Bei Schnurlostelefonen nach dem DECT-Standard kann beispielsweise folgende Situation auftreten. Das Mobilteil wird auf die Basisstation über ein Synchronisationswort synchronisiert, welches Bestandteil des S-Feldes eines Zeitschlitzes ist. Ein digitaler Signalprozessor wird auf die detektierte Synchronisationsposition synchronisiert, indem das Programm des digitalen Signalprozessors verkürzt oder verlängert wird. Das bedeutet, daß die vom digitalen Signalprozessor im Mobilteil ausgegebenen Daten synchron zur Taktrate der Basisstation sind. Die nachgeordnete Einheit bzw. Einheiten des Signalwandlers im Mobilteil hingegen arbeiten mit einem lokalen Oszillator und einer festen Abtastrate. Aufgrund der Frequenzabweichungen, welche zwischen Basisstation und Mobilteil im ungünstigsten Fall 35 ppm betragen können, treten unvermeidlich Abtastwertverluste oder Abtastwertaufdopplungen (Phasensprünge) an der Schnittstelle zwischen digitalem Signalprozessor und nachgeordneter Einheit bzw. Einheiten auf. Diese Störungen sind für die Übertragung von Modemsignalen nicht akzeptabel.

Aus der US-A-5132642 sind bereits ein Verfahren und eine Vorrichtung zur Synchronisation zweier Taktsignale bekannt. Durch die aus dieser Druckschrift bekannten Verfahren und Vorrichtungen zur Synchronisation zweier Taktsignale lassen sich die vorstehend erwähnten Probleme jedoch nicht oder zumindest nicht zufriedenstellend lösen.

Die Aufgabe der Erfindung ist es, eine Vorrichtung und ein Verfahren zur Synchronisation zweier Taktsignale anzugeben, bei welchen die obengenannten Störungen minimiert werden.

Vorteilhafter Weise kann dadurch die Übertragungsbitrate für Modemsignale optimiert werden.

Die Aufgabe wird erfindungsgemäß durch die in Patentanspruch 1 beanspruchte Vorrichtung und das in Patentanspruch 9 beanspruchte Verfahren gelöst.

Die erfindungsgemäße Vorrichtung gemäß dem Patentanspruch 1 und das erfindungsgemäße Verfahren gemäß dem Patentanspruch 9 zeichnen sich insbesondere dadurch aus, daß die Regeleinrichtung durch ein Referenztaktsignal mit konstanter Frequenz getaktet wird, und daß die Verringerung oder Erhöhung des zeitlichen Abstandes der im höherfrequenten Taktsignal vorhandenen Flanken derart durchgeführt wird, daß die im höherfrequenten Taktsignal vorhandenen Flanken nur zu Zeitpunkten auftreten, zu welchen auch im Referenztaktsignal eine Flanke auftritt.

Vorteilhafte Weiterbildungen ergeben sich aus den abhängigen Ansprüchen.

Die Vorrichtung gemäß Patentanspruch 1 läßt sich unter anderem in einem Signalwandler einsetzen. Der Signalwandler kann zur Gewinnung des niederfrequenteren Taktsignals einen Burstmodecontroller aufweisen, dem ein digitaler Signalprozessor nachgeschaltet ist und der mit dem vom Burstmodecontroller erzeugten niederfrequenteren Taktsignal getaktet wird. Weiterhin kann ein Filter vorgesehen sein, welches mit dem digitalen Signalprozessor verbunden ist und mit dem von der Regeleinrichtung erzeugten höherfrequenten Taktsignal getaktet wird. Die Regeleinrichtung dient zur Synchronisation des höherfrequenten Taktsignals mit dem niederfrequenteren Taktsignal, wobei die Führungsgröße der Regeleinrichtung durch das niederfrequentere Taktsignal vorgegeben ist und die Regelgröße der Regeleinrichtung das höherfrequente Taktsignal ist.

Die Regeleinrichtung kann einen Taktgenerator umfassen, der einen Regeldifferenzeingang und einen Regeldifferenzausgang, an dem das höherfrequente Taktsignal anliegt, aufweist. Zusätzlich kann ein Phasenvergleicher vorgesehen sein, der einen ersten Eingang für das höherfrequente Taktsignal, und einen zweiten Eingang für das niederfrequentere Taktsignal, und einen Regeldifferenzausgang aufweist. Der Regeldifferenzausgang des Phasenvergleichers ist mit dem Regeldifferenzeingang des Taktgenerators verbunden.

Vorteilhafter Weise wird die Phase des höherfrequenten Taktsignals mit der Phase des niederfrequenteren Taktsignals verglichen, und wenn die Phasen der beiden Signale voneinander abweichen, wird der Impulsabstand im höherfrequenten Taktsignal zeitweilig vergrößert oder verkleinert.

Zwischen das Filter und den digitalen Signalprozessor kann ein Jitterfilter geschaltet sein.

Zur Erzeugung eines Referenztakts ist vorteilhafter Weise ein Oszillator vorgesehen. Der Referenztakt dient zum Takten des Taktgenerators der Regeleinrichtung und ggf. unter Zwischen schaltung eines Frequenzteilers zum Takten eines Codecs, welcher mit dem Filter verbunden ist.

Die Erfindung wird im folgenden anhand von drei Figuren weiter erläutert.
- Figur 1: zeigt ein Blockdiagramm des erfindungsgemäßen Signalwandlers.
- Figur 2: zeigt ein Zustandsdiagramm zur Einstellung der Impulsabstände.
- Figur 3: zeigt ein Zeitdiagramm mit einem Referenztakt, einem unveränderten, einem verkürzten und einem verlängerten Taktsignal.

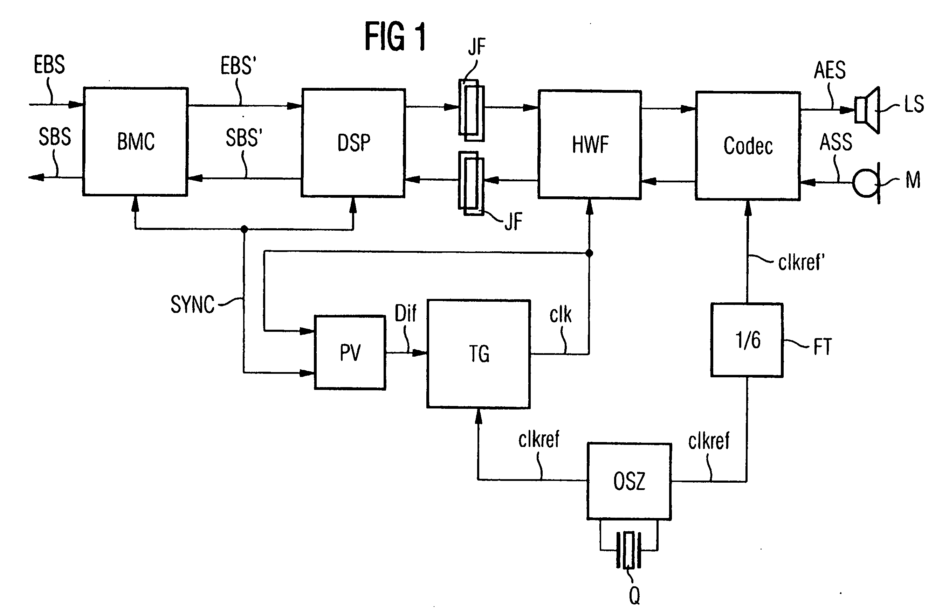

Bei dem in Figur 1 gezeigten Signalwandler ist ein Burstmodecontroller BMC vorgesehen, der als Eingangssignal einen Empfangsbitstrom EBS und als sendeseitiges Ausgangssignal einen Sendebitstrom SBS aufweist. Der Burstmodecontroller BMC reicht einen Empfangsbitstrom EBS' an einen digitalen Signalprozessor DSP weiter und erhält von diesem einen Sendebitstrom SBS'. Aus dem Empfangsbitstrom EBS erzeugt der Burstmodecontroller BMC ein Synchronisationssignal SYNC. Beim DECT-Standard kann das Synchronisationssignal SYNC eine Frequenz von 8 kHz aufweisen. Dieses Synchronisationssignal SYNC wird dem digitalen Signalprozessor DSP und einem Phasenvergleicher PV zugeführt, wobei der digitale Signalprozessor DSP mit dem Synchronisationssignal SYNC getaktet wird. Das Ausgangssignal des digitalen Signalprozessors DSP wird über einen Jitterfilter JF einem Hardwarefilter HWF zugeführt. Umgekehrt wird das vom Hardwarefilter HWF erzeugte Signal über einen zweiten Jitterfilter JF dem digitalen Signalprozessor DSP zugeführt. Das Hardwarefilter HWF wird mit einem Taktsignal clk getaktet, welches von einer Regeleinrichtung stammt. Beim DECT-Standard kann die Frequenz des Taktsignals clk z. B. 3,456 Mhz betragen. Das Taktsignal CLK und das Synchronisationssignal SYNC werden einem Phasenvergleicher PV, welcher Bestandteil der Regeleinrichtung ist, zugeführt. Die PhasenDifferenz der beiden Signale wird einem Taktgenerator TG, der ebenfalls Bestandteil der Regeleinrichtung ist, zugeführt, welche unter Verwendung eines Referenztakts clkref das Taktsignal clk erzeugt. Das Referenztaktsignal clkref stammt von einem mit 10,368 MHz schwingenden Quarzoszillator OSZ. Mit Q ist in der Figur 1 der Quarz des Oszillators OSZ bezeichnet. Über einen Frequenzteiler wird das durch einen Faktor 6 geteilte Referenztaktsignal clkref als geteiltes Referenztaktsignal clkref' einem Codec CODEC zur Taktsteuerung zugeführt. Der Codec CODEC setzt das vom Hardwarefilter HWF stammende Signal in ein analoges Empfangssignal AES um, welches mittels eines Lautsprechers LS hörbar gemacht werden kann. Das beispielsweise von einem Mikrophon M stammende analoge Sendesignal ASS wird von dem Codec CODEC in ein digitales Signal umgesetzt und dem Hardwarefilter HWF zugeführt.

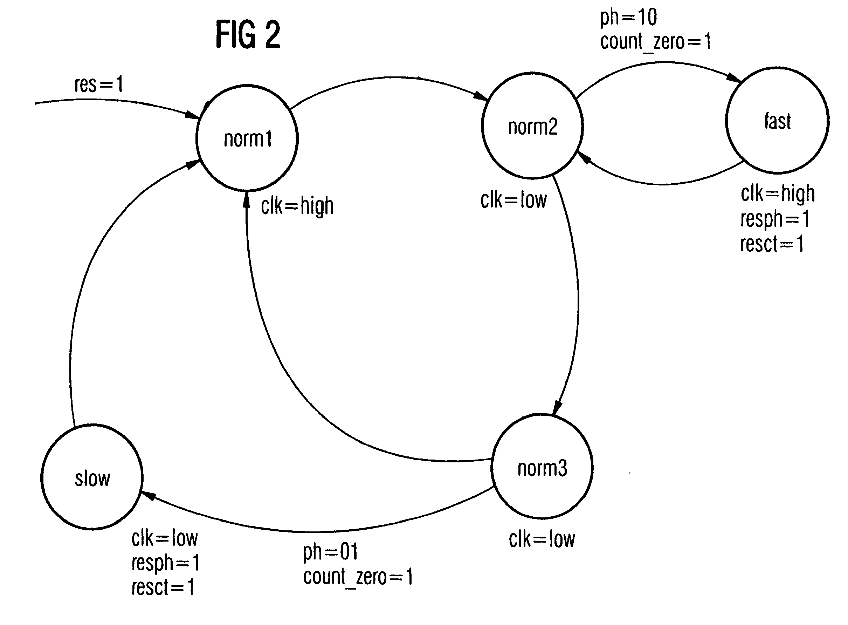

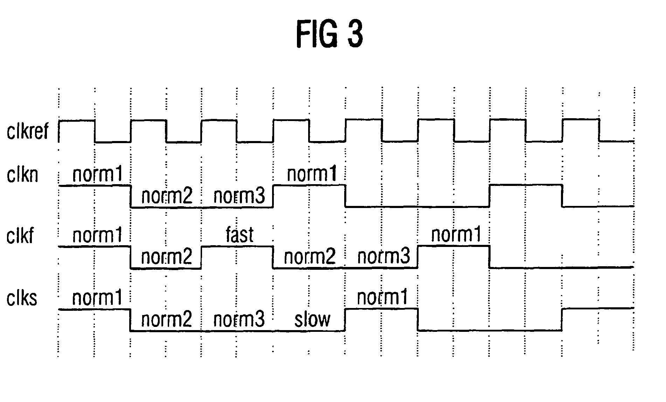

Das Zustandsdiagramm in Figur 2 dient zur Erläuterung, wie aus der Regeldifferenz unter Verwendung des Referenztaktsignals clkref ein entsprechendes Taktsignal clk gewonnen werden kann. Beginnend beim Zustand norm1, welcher für die Taktsignale clkn, clkf und clks in Figur 3 links gezeigt ist, erfolgt beim Wechsel des Pegels des Referenztaktsignals clkref in den Zustand "high" ein Übergang zum Zustand norm2. Wechselt der Pegel des Referenztaktsignals clkref in den Zustand "low" und stellt der Phasenvergleicher PV keine Phasendifferenz fest, d. h. die Variableph weist den Wert 01 auf, wird in den nächsten Zustand norm3 übergegangen. Falls der Phasendetektor PV jedoch eine Phasendifferenz erkannt hat, und die Variable ph auf 10 gesetzt ist, sowie der Wert count-zero auf 1 liegt, wird nicht in den Zustand norm3, sondern in den Zustand "fast" gesprungen. Das bedeutet, daß beim nächsten Wechsel des Referenztakts clkref in den Zustand "high" das Taktsignal clk ebenfalls in den Zustand "high" wechselt. Anschließend wird beim Erreichen des nächsten High-Zustands des Referenztaktsignals clkref zum Zustand norm2 zurückgesprungen und das Taktsignal clk wechselt in den Zustand "low". Beim Übergang auf den Zustand norm3 wird für das Taktsignal clk der Pegel "low" beibehalten. Abhängig vom Wert der Variablen ph und count-Zero wird entweder in den Zustand norm1 oder aber in den Zustand "slow" gesprungen. Weist die Variable ph den Wert 01 und die Variable count-Zero den Wert 1 auf, so wird im Zustand "slow" der Pegel des Taktsignals clk auf "low" beibehalten. Bedingungsunabhängig wird anschließend zum Zustand norm1 zurückgesprungen. Mit der Variablen res kann ein Rücksetzen erfolgen.

Das Taktsignal clk ist in Figur 3 einmal als unverändertes oder normales Taktsignal clkn, einmal als beschleunigtes Taktsignal clkf und einmal als verzögertes Taktsignal clks gezeigt. Die Beschleunigungs- bzw. Verzögerungsdauer entspricht jeweils einer Periode des Referenztaktsignals clkref.

Die Fehlerminimierung erfolgt, indem die unvermeidlichen Datenverluste auf die Komponenten verschoben werden, die dem Hardwarefilter HWF folgen. Dort auftretende Datenverluste wirken sich weitaus schwächer auf die Signalform aus, als Phasensprünge im Datenstrom zwischen Signalprozessor DSP und Hardewarefilter HWF.

Zusätzlich sind die Störenergien kleiner und haben aufgrund der wesentlich höheren Abtastrate (im vorliegenden Ausführungsbeispiel 1,728 MHz) schwächere Auswirkungen.

Ein Verlust der Synchronisation der Taktsignale wird durch Aufdoppeln bzw. Weglassen von Informationen oder durch Interpolation- und Dezimation von Informationen ausgeglichen, wobei der Verlust der Synchronisation der Taktsignale bei einer Abtastfrequenz ausgeglichen wird, die höher ist als die Frequenz der zu synchronisierenden Taktsignale, vorzugsweise bei der höchsten verfügbaren Abtastfrequenz.

Eine weitere Störungsminimierung wird dadurch erreicht, daß die Bitverluste über einen großen Zeitraum verteilt werden, d. h. nicht burstartig auftreten. Das wird durch eine digitale Verzögerung im Phasenvergleicher PV der Regeleinrichtung erreicht.

Die Erfindung ist auf alle Vorrichtungen anwendbar, bei denen mehrere Taktsignale mit verschiedenen Taktfrequenzen vorhanden sind, wenigstens zwei der Taktsignale jedoch zu synchronisieren sind. Die Synchronisation erfolgt vorzugsweise bei der höchsten verfügbaren Abtastfrequenz.

## Patentansprüche

1. Vorrichtung zur Synchronisation zweier Taktsignale (SYNC, clk) mit unterschiedlicher Taktfrequenz, mit einer Regeleinrichtung (PV, TG), die die beiden Taktsignale (SYNC, clk) miteinander vergleicht und die Phasenlage des höherfrequenten Taktsignals (clk) an die des niederfrequenteren Taktsignals (SYNC) anpaßt, **dadurch gekennzeichnet, dass** die Regeleinrichtung durch ein Referenztaktsignal (clkref) mit konstanter Frequenz getaktet wird, und wobei die Anpassung der Phasenlage des höherfrequenten Taktsignals (clk) derart erfolgt, daß die im höherfrequenten Taktsignal vorhandenen Flanken nur zu Zeitpunkten auftreten, zu welchen auch im Referenztaktsignal eine Flanke auftritt.

2. Vorrichtung nach Anspruch 1,
**dadurch gekennzeichnet, daß** die Vorrichtung zum Einsatz in einem Signalwandler ausgelegt ist, der folgende Komponenten enthält :
- ein Mittel (BMC) zur Gewinnung des niederfrequenteren Taktsignals (SYNC) aus einem Bitstrom (EBS),
- ein Mittel (DSP) zur Signalverarbeitung, welches mit dem Mittel (BMC) zur Gewinnung des niederfrequenteren Taktsignals (SYNC) verbunden ist und mit dem niederfrequenteren Taktsignal (SYNC) getaktet wird,
- ein Filter (HWF), welches mit dem Mittel (DSP) zur Signalverarbeitung verbunden ist und mit dem höherfrequenten Taktsignal (clk) getaktet wird, und
- die Regeleinrichtung (PV, TG) zur Synchronisation des höherfrequenten Taktsignals (clk) mit dem niederfrequenteren Taktsignal (SYNC), wobei die Führungsgröße der Regeleinrichtung durch das niederfrequentere Taktsignal (SYNC) vorgegeben ist, und die Regelgröße der Regeleinrichtung das höherfrequente Taktsignal (clk) ist.

3. Vorrichtung nach Anspruch 1 oder 2,
**dadurch gekennzeichnet,**
**daß** die Regeleinrichtung (PV, TG)
- einen Taktgenerator (TG) umfaßt, der einen Regeldifferenzeingang und einen Taktsignalausgang, an dem das höherfrequente Taktsignal (clk) anliegt, aufweist, und
- einen Phasenvergleicher (PV) umfaßt, der einen ersten Eingang für das höherfrequente Taktsignal (clk), einen zweiten Eingang für das niederfrequentere Taktsignal (SYNC) und einen Regeldifferenzausgang aufweist, der mit dem Regeldifferenzeingang des Taktgenerators (TG) verbunden ist.

4. Vorrichtung nach Anspruch 2 oder 3,
**dadurch gekennzeichnet,**
**daß** die Phase des höherfrequenten Taktsignals (clk) mit der Phase des niederfrequenteren Taktsignals (SYNC) verglichen wird, und wenn diese voneinander abweichen, der Impulsabstand im höherfrequenten Taktsignal (clk) zeitweilig vergrößert oder verkleinert wird.

5. Vorrichtung nach einem der Ansprüche 2 bis 4,
**dadurch gekennzeichnet,**
**daß** der Signalwandler ferner ein Jitterfilter (JF) enthält, das zwischen das Mittel (DSP) zur Signalverarbeitung und das Filter (HWF) geschaltet ist.

6. Vorrichtung nach einem der Ansprüche 2 bis 5,
**dadurch gekennzeichnet,**
**daß** der Signalwandler ferner einen Oszillator (OSZ) zur Erzeugung eines Referenztakts (clkref) für den Taktgenerator (TG) enthält, und einen Codec (CODEC) enthält, wobei der Codec (CODEC) mit dem Filter (HWF) verbunden ist.

7. Vorrichtung nach Anspruch 6,
**dadurch gekennzeichnet,**
**daß** der Signalwandler ferner einen Frequenzteiler (FT) enthält, der zwischen den Oszillator (OSZ) und den Codec (CODEC) geschaltet ist.

8. Vorrichtung nach einem der Ansprüche 2 bis 7,
**dadurch gekennzeichnet,**
**daß** die Regeleinrichtung (PV, TG) mit der höchsten verfügbaren Taktfrequenz arbeitet.

9. Verfahren zur Synchronisation zweier Taktsignale (SYNC, clk) mit unterschiedlicher Taktfrequenz in einem Signalwandler, bei dem mittels einer Regeleinrichtung (PV, TG) die beiden Taktsignale (SYNC, clk) miteinander verglichen werden, und falls eine Regelabweichung vorliegt, der zeitliche Abstand der im höherfrequenten Taktsignal (clk) vorhandenen Flanken entsprechend der Regelabweichung verringert oder erhöht wird, **dadurch gekennzeichnet, dass** die Regeleinrichtung (PV, TG) durch ein Referenztaktsignal (clkref) mit konstanter Frequenz getaktet wird, und wobei die Verringerung oder Erhöhung des zeitlichen Abstandes der im höherfrequenten Taktsignal (clk) vorhandenen Flanken derart durchgeführt wird, daß die im höherfrequenten Taktsignal (clk) vorhandenen Flanken nur zu Zeitpunkten auftreten, zu welchen auch im Referenztaktsignal (refclk) eine Flanke auftritt.

## Claims

1. Apparatus for synchronization of two clock signals (SYNC, clk) with a different clock frequency, having a control device (PV, TG), which compares the two clock signals (SYNC, clk) with one another and matches the phase angle of the higher-frequency clock signal (clk) to that of the lower-frequency clock signal (SYNC), **characterized in that** the control device is clocked by a reference clock signal (clkref) at a constant frequency, and with the phase angle of the higher-frequency clock signal (clk) being matched such that the flanks which are present in the higher-frequency clock signal occur only at times at which a flank also occurs in the reference clock signal.

2. Apparatus according to Claim 1,
**characterized in that**
the apparatus is designed for use in a signal converter which contains the following components:
- a means (BMC) for obtaining a lower-frequency clock signal (SYNC) from a bit stream (EBS),
- a means (DSP) for signal processing, which is connected to the means (BMC) for obtaining a lower-frequency clock signal (SYNC) and is clocked by the lower-frequency clock signal (SYNC),
- a filter (HWF) which is connected to the means (DSP) for signal processing and is clocked by the higher-frequency clock signal (clk), and
- the control device (PV, TG) for synchronization of the higher-frequency clock signal (clk) to the lower-frequency clock signal (SYNC), with the reference variable for the control device being predetermined by the lower-frequency clock signal (SYNC), and with the controlled variable for the control device being the higher-frequency clock signal (clk).

3. Apparatus according to Claim 1 or 2,
**characterized in that**
the control device (PV, TG)
- has a clock generator (TG) which has a control difference input and a clock signal output, at which the higher-frequency clock signal (clk) is produced, and
- has a phase comparator (PV) which has a first input for the higher-frequency clock signal (clk), a second input for the lower-frequency clock signal (SYNC) and a control difference output which is connected to the control difference input of the clock generator (TG).

4. Apparatus according to Claim 2 or 3,
**characterized in that**
the phase of the higher-frequency clock signal (clk) is compared with the phase of the lower-frequency clock signal (SYNC) and, if they differ from one another, the pulse separation in the higher-frequency clock signal (clk) is temporarily increased or decreased.

5. Apparatus according to one of Claims 2 to 4,
**characterized in that**
the signal converter also contains a jitter filter (JF), which is connected between the means (DSP) for signal processing and the filter (HWF).

6. Apparatus according to one of Claims 2 to 5,
**characterized in that** the signal converter furthermore contains an oscillator (OSZ) for production of a reference clock (clkref) for the clock generator (TG), and contains a codec (CODEC), with the codec (CODEC) being connected to the filter (HWF).

7. Apparatus according to Claim 6, **characterized in that** the signal converter also contains a frequency divider (FT) which is connected between the oscillator (OSZ) and the codec (CODEC).

8. Apparatus according to one of Claims 2 to 7, **characterized in that** the control device (PV, TG) operates using the highest available clock frequency.

9. Method for synchronization of two clock signals (SYNC, clk) with a different clock frequency in a signal converter, in which a control device (PV, TG) is used to compare the two clock signals (SYNC, clk) with one another and, if there is any control discrepancy, the time interval between the flanks in the higher-frequency clock signal (clk) is decreased or increased in accordance with the control discrepancy, **characterized in that** the control device (PV, TG) is clocked by a reference clock signal (clkref) at a constant frequency, and with the time interval between the flanks in the higher-frequency clock signal (clk) being increased or decreased such that the flanks which are present in the higher-frequency clock signal (clk) occur only at times at which a flank also occurs in the reference clock signal (refclk).

## Revendications

1. Dispositif pour la synchronisation de deux signaux de rythme (SYNC, clk) avec une fréquence de rythme différente, avec un dispositif de réglage (PV, TG), qui compare les deux signaux de rythme (SYNC, clk) entre eux et adapte la position de phase du signal de rythme (clk) à fréquence plus élevée à celle du signal de rythme (SYNC) à fréquence plus basse, **caractérisé en ce que** le dispositif de réglage est synchronisé par un signal de rythme de référence (clkref) avec une fréquence constante, et l'adaptation de la position de phase du signal de rythme (clk) à fréquence plus élevée s'effectuant de telle sorte que les flancs présents dans le signal de rythme à fréquence plus élevée n'apparaissent qu'à des moments où un flanc apparaît également dans le signal de rythme de référence.

2. Dispositif selon la revendication 1, le dispositif étant conçu pour une utilisation dans un convertisseur de signal, **caractérisé par** :
- un moyen (BMC) pour l'obtention du signal de rythme (SYNC) à fréquence plus basse à partir d'un flux binaire (EBS),
- un moyen (DSP) pour le traitement du signal, qui est relié au moyen (BMC) pour l'obtention du signal de rythme (SYNC) à fréquence plus basse et est synchronisé avec le signal de rythme (SYNC) à fréquence plus basse,
- un filtre (HWF), qui est relié au moyen (DSP) pour le traitement du signal et est synchronisé avec le signal de rythme (clk) à fréquence plus élevée, et
- le dispositif de réglage (PV, TG) pour la synchronisation du signal de rythme (clk) à fréquence plus élevée avec le signal de rythme (SYNC) à fréquence plus basse, la grandeur de guidage du dispositif de réglage étant prédéfinie par le signal de rythme (SYNC) à fréquence plus basse, et la grandeur de réglage du dispositif de réglage étant le signal de rythme (clk) à fréquence plus élevée.

3. Dispositif selon la revendication 1 ou 2,
**caractérisé en ce que**
le dispositif de réglage (PV, TG)
- comporte un générateur de rythme (TG), qui présente une entrée de différence de réglage et une sortie de signal de rythme, à laquelle s'applique le signal de rythme (clk) à fréquence plus élevée, et
- comporte un comparateur de phase (PV), qui présente une première entrée pour le signal de rythme (clk) à fréquence plus élevée, une seconde entrée pour le signal de rythme (SYNC) à fréquence plus basse et une sortie de différence de réglage, qui est reliée à l'entrée de différence de réglage du générateur de rythme (TG).

4. Dispositif selon la revendication 2 ou 3,
**caractérisé en ce que**
la phase du signal de rythme (clk) à fréquence plus élevée est comparée avec la phase du signal de rythme (SYNC) à fréquence plus basse, et lorsque ces phases divergent, l'espacement d'impulsion est agrandi ou réduit temporairement dans le signal de rythme (clk) à fréquence plus élevée.

5. Dispositif selon l'une quelconque des revendications 2 à 4,
**caractérisé en ce que**
le convertisseur de signal contient également un filtre à gigue (JF), qui est branché entre le moyen (DSP) pour le traitement du signal et le filtre (HWF).

6. Dispositif selon l'une quelconque des revendications 2 à 5,
**caractérisé en ce que**
le convertisseur de signal contient également un oscillateur (OSZ) pour la génération d'un rythme de référence (clkref) pour le générateur de rythme (TG), et contient un Codec (CODEC), le Codec (CODEC) étant relié au filtre (HWF).

7. Dispositif selon la revendication 6,
**caractérisé en ce que**
le convertisseur de signal contient également un diviseur de fréquence (FT) qui est branché entre l'oscillateur (OSZ) et le Codec (CODEC).

8. Dispositif selon l'une quelconque des revendications 2 à 7,
**caractérisé en ce que**
le dispositif de réglage (PV, TG) travaille avec la fréquence de rythme disponible la plus élevée.

9. Procédé pour la synchronisation de deux signaux de rythme (SYNC, clk) avec une fréquence de rythme différente dans un convertisseur de signal, dans lequel les deux signaux de rythme (SYNC, clk) sont comparés entre eux au moyen d'un dispositif de réglage (PV, TG) et lorsqu'on a un écart de réglage, l'espacement dans le temps des flancs présents dans le signal de rythme (clk) de fréquence plus élevée est réduit ou augmenté en fonction de l'écart de réglage, **caractérisé en ce que** le dispositif de réglage (PV, TG) est synchronisé par un signal de rythme de référence (clkref) avec une fréquence constante, et la réduction ou l'élévation de l'espacement dans le temps des flancs présents dans le signal de rythme (clk) à fréquence plus élevée étant effectuée de telle sorte que les flancs présents dans le signal de rythme (clk) à fréquence plus élevée n'apparaissent qu'à des moments où un flanc apparaît également dans le signal de rythme de référence (refclk).
